# EUROPEAN PATENT SPECIFICATION

(11) **EP 2 930 565 B1**
(45) Date of publication and mention of the grant of the patent: **30.11.2016**
(21) Application number: 15162945.8
(22) Date of filing: 09.04.2015
(51) Int. Cl.: G03F 7/42

(54) **STRIPPING SOLUTION FOR PHOTOLITHOGRAPHY AND PATTERN FORMING PROCESS**
ENTSCHICHTUNGSLÖSUNG FÜR FOTOLITHOGRAFIE UND MUSTERBILDUNGSVERFAHREN
SOLUTION DE DÉCAPAGE POUR PHOTOLITHOGRAPHIE ET PROCÉDÉ DE FORMATION DE MOTIF

(30) Priority: 09.04.2014 JP 2014080576
(43) Date of publication of application: 14.10.2015
(73) Proprietor: TOKYO OHKA KOGYO CO., LTD., Kawasaki-shi, Kanagawa, 211-0012 (JP)
(72) Inventor: Ueno, Naohisa, Kanagawa 211-0012 (JP)
(74) Representative: Cabinet Plasseraud

(56) References cited:
- WO-A1-2009/146606
- US-A1- 2006 287 207
- US-A1- 2014 087 313

## Description

### BACKGROUND OF THE INVENTION

### Field of the Invention

The present invention relates to a stripping solution for photolithography which can be suitably used in manufacture of semiconductor elements such as IC and LSI as well as liquid crystal panel elements, and to a method for forming a pattern using the same.

### Related Art

When semiconductor elements such as IC and LSI, or liquid crystal panel elements are manufactured, a CVD vapor-deposited metal film or an insulating film such as a SiO₂ film is first formed on a substrate such as a silicon wafer or glass. Next, a photoresist composition is uniformly applied on the metal film or the insulating film to form a photoresist film. This photoresist film is selectively exposed and developed to form a photoresist pattern. Then, the substrate is subjected to an etching treatment using the photoresist pattern as a mask to form a fine circuit. Thereafter, the photoresist pattern is ashed. Residual materials of the ashed photoresist pattern, and etching residual materials are stripped away using a stripping solution for photolithography.

It is to be noted that aluminum (Al); an aluminum alloy (Al alloy) such as aluminum-silicon (Al-Si), aluminum-copper (Al-Cu) or aluminum-silicon-copper (Al-Si-Cu); titanium (Ti); a titanium alloy (Ti alloy) such as titanium nitride (TiN) or titanium tungsten (TiW); tantalum (Ta), tantalum nitride (TaN), tungsten (W), tungsten nitride (WN), copper (Cu) or the like may be used as the metal film described above. Furthermore, not only the metal film and the insulating film, an interlayer insulating film such as an organic SOG (spin-on glass) film may be also adopted. The metal film, insulating film, interlayer insulating film and the like are formed on the substrate as a single layer or a plurality of layers.

The stripping solution for photolithography is desired to have an ability to effectively strip residual materials of a photoresist pattern and etching residual materials, and be superior in anticorrosion properties on metals. In order to achieve both performances, use of hydrofluoric acid and a compound containing ammonia as a counter amine thereof (see Patent Documents 1 to 3), hydrofluoric acid and a compound containing 1,8-diazabicyclo[5.4.0]undecene-7 as a counter amine thereof (see Patent Document 4), or the like has been proposed so far.

The stripping solution is cyclically used in some cases, when photoresist pattern residues and etching residues are stripped away using such a stripping solution. In such a case, the stripping solution is desired to maintain constant performance characteristics over time.

Investigations performed by the present inventors revealed that continuous recycling of the stripping solution for photolithography disclosed in Patent Documents 1 to 4 for a long period of time leads to problems of: deteriorated performances of stripping residual materials of a photoresist pattern and etching residual materials as the composition alters; and progression of metal corrosion. In addition, when the stripping solution is used under heating conditions in attempts to improve the stripping performances, the aforementioned problems were found to be more significant.

In view of these problems, a stripping solution for photolithography, has been proposed (Patent Document 5), that can effectively strip away photoresist pattern residues and etching residues, has an excellent anticorrosion property with respect to metals, and can be continuously used for a long time. Specifically, Patent Document 5 proposes a stripping solution for photolithography containing hydrofluoric acid, a basic compound having a specific structure such as diethylenetriamine and triethylenetetramine, and water.
Patent Document 1: Japanese Unexamined Patent Application, Publication No. 2001-83713
Patent Document 2: Japanese Unexamined Patent Application, Publication No. H09-197681
Patent Document 3: Japanese Unexamined Patent Application, Publication No. 2000-47401
Patent Document 4: Japanese Unexamined Patent Application, Publication No. 2000-181083
Patent Document 5: Japanese Unexamined Patent Application, Publication No. 2013-097193

### SUMMARY OF THE INVENTION

The stripping solution described in Patent Document 5 can indeed maintain the high ability of stripping away photoresist pattern residues and etching residues and an excellent anticorrosion property with respect to metals, even if the stripping solution is cyclically used.

The precision levels of machining required in manufacturing various elements, for example, semiconductor elements, such as IC and LSI, and liquid crystal panel elements, are increasing on a daily basis. However, the cyclic use of the stripping solution described in Patent Document 5, has a problem where the etching rate decreases with time, although the high level of anticorrosion property with respect to metals of the stripping solution is maintained to some extent.

Such a change in the etching rate during the cyclic use of a stripping solution may cause a variation in the performance of element products of different production lots due to a slight difference in the film thickness of a metal or metal oxide included in the element product.

The present invention has been made in view of the foregoing problems, and an object of the invention is to provide a stripping solution for photolithography that can effectively strip away photoresist pattern residues and etching residues, that has an excellent anticorrosion property with respect to metals, and can maintain a high ability of stripping without a substantial change in etching rate even if continuously used for a long time; and a pattern forming process using the stripping solution.

The present inventors have found that the above-described problems can be solved by using a basic compound having a predetermined structure as a counter amine of hydrofluoric acid contained in the stripping solution and adding an N,N-dialkyl fatty acid amide having a specific structure to the stripping solution as an organic solvent, and have accomplished the present invention. More specifically, the present invention includes the following aspects.

A first aspect of the present invention relates to a stripping solution for photolithography characterized in that it comprises:
(A) hydrofluoric acid;
   a (B) basic compound represented by formula (b-1): 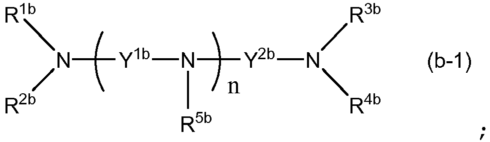
(C) water; and
   a (D) organic solvent , wherein
   the (D) organic solvent comprises an N,N-dialkyl fatty acid amide represented by formula (d-1):

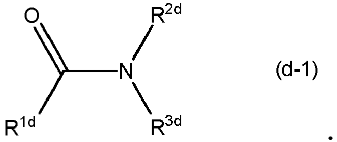

In the general formula (b-1), R^{1b} to R^{5b} each independently represent a hydrogen atom, or an alkyl group having 1 to 6 carbon atoms which may be substituted with a hydroxyl group, a carboxyl group, an amino group or a phosphonic acid group, and at least one of R^{1b} to R^{5b} represents a hydrogen atom;
one of R^{1b} to R^{4b} optionally bind with R^{5b} to form a ring structure;
Y^{1b} and Y^{2b} each independently represent an alkylene group having 1 to 3 carbon atoms;
n is an integer of 0 to 5; and
provided that n is 2 or greater, a plurality of R^{5b}s may be each the same or different and a plurality of Y^{1b}s may be each the same or different, and R^{5b}s optionally bind with each other to form a ring structure.

In the general formula (d-1), R^{1d} represents an isopropyl group or a 1-hydroxy-1-methylethyl group; and R^{2d} and R^{3d} each independently represent an alkyl group having 1 to 4 carbon atoms.

A second aspect of the present invention provides a method for forming a pattern characterized in that it comprises:
etching a substrate using a photoresist pattern provided on the substrate as a mask;
ashing the photoresist pattern; and
stripping away the residual materials of the photoresist pattern and etching residual materials using the stripping solution for photolithography of the first aspect of the present invention.

The present invention can provide a stripping solution for photolithography that can effectively strip away photoresist pattern residues and etching residues, has an excellent anticorrosion property with respect to metals, and can maintain a high ability of stripping without a substantial change in etching rate even if continuously used for a long time; and provide a pattern forming process using the stripping solution.

### DETAILED DESCRIPTION OF THE INVENTION

### Stripping solution for photolithography

The stripping solution for photolithography (hereinafter, simply referred to as "stripping solution") according to the present invention contains (A) hydrofluoric acid, a (B) basic compound having a specific structure, (C) water, and a (D) organic solvent comprising an N,N-dialkyl fatty acid amide having a specific structure. Each ingredient contained in the stripping solution according to the present invention will now be described.

### (A) Hydrofluoric Acid

The stripping solution according to the present invention essentially contains (A) hydrofluoric acid.

The content of the (A) hydrofluoric acid in the stripping solution is preferably 0.05 to 0.5% by mass, and more preferably 0.08 to 0.32% by mass. When the content of the (A) hydrofluoric acid falls within such a range, stripping properties of residual materials of a photoresist pattern and etching residual materials can be more effectively balanced with anticorrosion properties on metals.

### (B) Basic Compound

The stripping solution according to the present invention essentially contains a (B) basic compound represented by the following general formula (b-1):

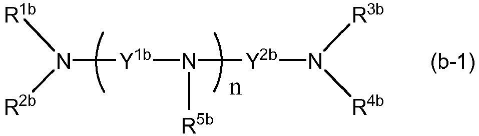

In the general formula (b-1), R^{1b} to R^{5b} each independently represent a hydrogen atom, or an alkyl group having 1 to 6 carbon atoms which may be substituted with a hydroxyl group, a carboxyl group, an amino group or a phosphonic acid group, and at least one of R^{1b} to R^{5b} represents a hydrogen atom; one of R^{1b} to R^{4b} optionally bind with R^{5b} to form a ring structure;
Y^{1b} and Y^{2b} each independently represent an alkylene group having 1 to 3 carbon atoms;
n is an integer of 0 to 5; and
provided that n is 2 or greater, a plurality of R^{5b}s may be each the same or different and a plurality of Y^{1b}s may be each the same or different, R^{5b}s optionally bind with each other to form a ring structure.

The alkyl group having 1 to 6 carbon atoms which may be included in R^{1b} to R^{5b} may be either linear or branched, and is preferably linear. Specific examples of the alkyl group having 1 to 6 carbon atoms include a methyl group, an ethyl group, a n-propyl group, a n-butyl group, a n-pentyl group, a n-hexyl group, and the like. Of these, an ethyl group is most preferred.

The alkyl group may be substituted with a hydroxyl group, a carboxyl group, an amino group, or a phosphonic acid group. Specific examples of such a substituted alkyl group include a 2-hydroxyethyl group, a 2-carboxyethyl group, a 2-aminoethyl group, a 2-phosphonic ethyl group ((HO)₂P(=O)-CH₂CH₂-), and the like.

The ring structure which may be formed by binding one of R^{1b} to R^{4b} with R^{5b}, or the ring structure which may be formed by binding of R^{5b}s with each other includes a piperazine ring, and the like.

The alkylene group having 1 to 3 carbon atoms which may be represented by Y^{1b} and Y^{2b} may be either linear or branched, and is preferably linear. Specific examples of the alkylene group include a methylene group, an ethylene group, a propylene group, and the like. Of these, an ethylene group is most preferred.

"n" is an integer of 0 to 5, and more preferably an integer of 0 to 2.

Specific examples of the (B) basic compound represented by the above general formula (b-1) include ethylenediamine, N-(2-aminoethyl)-1,2-ethanediamine (i.e., diethylenetriamine), N,N'-bis(2-aminoethyl)-1,2-ethanediamine (i.e., triethylenetetramine), tris (2-aminoethyl)amine, N,N'-bis(2-aminoethyl)piperazine, N-[(2-aminoethyl)-2-aminoethyl]piperazine, N-(2-aminoethyl)-N'-{2-[(2-aminoethyl)amino]ethyl}-1,2-ethanediamine (i.e., tetraethylenepentamine), 4-(2-aminoethyl)-N-(2-aminoethyl)-N'-{2-[(2-aminoethyl)amino]ethyl}-1,2-ethanediamine, 1-(2-aminoethyl)-4-{[(2-aminoethyl)amino]ethyl}piperazine, 1-{2-[[2-[(2-aminoethyl)amino]ethyl]amino]ethyl}piperazine, 1-piperazineethaneamine, 2-[(2-aminoethyl)amino]ethanol, diethylenetriamine pentaacetic acid, and the like.

Among the (B) basic compounds represented by the above general formula (b-1), basic compounds represented by the following general formula (b-2) are preferred.

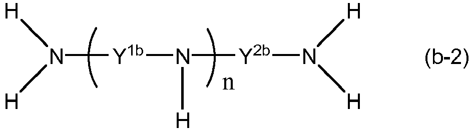

In the general formula (b-2), Y^{1b}, Y^{1b}, and n are as defined in the above general formula (b-1).

Specific examples of the (B) basic compound represented by the above general formula (b-2) include ethylenediamine, N-(2-aminoethyl)-1,2-ethanediamine (i.e., diethylenetriamine), N,N'-bis(2-aminoethyl)-1,2-ethanediamine (i.e., triethylenetetramine), tetraethylene pentamine, pentaethylene hexamine, dimethylenetriamine, trimethylenetetramine, and the like.

Of these, N-(2-aminoethyl)-1,2-ethanediamine (i.e., diethylenetriamine), and N,N'-bis(2-aminoethyl)-1,2-ethanediamine (i.e., triethylenetetramine) have superior anticorrosion properties on metals, and thus are particularly preferred in that continuous use for a longer time period is enabled.

These basic compounds may be used alone, or in combination of two or more compounds.

The content of the (B) basic compound represented by the above general formula (b-1) may be appropriately adjusted in accordance with the content of the (A) hydrofluoric acid, and is preferably 0.01 to 2.00% by mass, and more preferably 0.01 to 1.24% by mass in the stripping solution. In addition, a ratio of the normality (N) of the (B) basic compound to the normality (N) of the (A) hydrofluoric acid is preferably 0.1 to 3.0, and more preferably 0.1 to 1.5. When the ratio falls within such a range, stripping properties of residual materials of a photoresist pattern and etching residual materials can be more effectively balanced with anticorrosion properties on metals, and further continuous use for a longer period of time is enabled.

### (C) Water

The stripping solution according to the present invention essentially contains (C) water.

The content of the (C) water in the stripping solution is preferably 1.0 to 80% by mass, and more preferably 15 to 40% by mass.

### (D) Organic solvent

The stripping solution according to the present invention mandatorily contains a (D) organic solvent comprising an N,N-dialkyl fatty acid amide represented by the general formula (d-1). The stripping solution, having a property of etching rate which hardly changes even if continuously used, can be obtained through a simple process, i.e., addition of such a

### (D) organic solvent to the stripping solution.

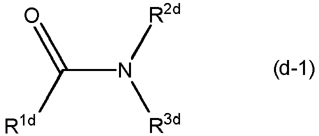

In the formula (d-1), R^{1d} represents an isopropyl group or a 1-hydroxy-1-methylethyl group; and R^{2d} and R^{3d} each independently represent an alkyl group having 1 to 4 carbon atoms.

R^{2d} and R^{3d} each independently represent an alkyl group having 1 to 4 carbon atoms. The alkyl group may be a linear or branched alkyl group. Examples of the alkyl group having 1 to 4 carbon atoms include methyl, ethyl, n-propyl, isopropyl, n-butyl, sec-butyl, isobutyl, and tert-butyl groups. Among these alkyl groups, methyl and ethyl groups are preferred.

Examples of the N,N-dialkyl fatty acid amide represented by formula (d-1) include N,N-dimethylisobutylamide, N-ethyl,N-methylisobutylamide, N,N-diethylisobutylamide, 2-hydroxy-N,N,2-trimethylpropaneamide, N-ethyl-2-hydroxy-N,2-dimethylpropaneamide, and N,N-diethyl-2-hydroxy-2-methylpropaneamide. Among these compounds, N,N-dimethylisobutylamide, N-ethyl,N-methylisobutylamide, 2-hydroxy-N,N,2-trimethylpropaneamide, and N-ethyl-2-hydroxy-N,2-dimethylpropaneamide are preferred; and N,N-dimethylisobutylamide and 2-hydroxy-N,N,2-trimethylpropaneamide are more preferred. The (D) organic solvent may be a combination of two or more N,N-dialkyl fatty acid amides.

The (D) organic solvent may include another water-soluble organic solvent together with the N,N-dialkyl fatty acid amide represented by formula (d-1).

Specific examples of the water soluble organic solvent include: sulfoxides such as dimethylsulfoxide; sulfones such as dimethylsulfone, diethylsulfone, bis(2-hydroxyethyl)sulfone and tetramethylenesulfone; amides such as N,N-dimethylformamide, N-methylformamide, N,N-dimethylacetamide, N-methylacetamide and N,N-diethyl acetamide; lactams such as N-methyl-2-pyrrolidone, N-ethyl-2-pyrrolidone, N-propyl-2-pyrrolidone, N-hydroxymethyl-2-pyrrolidone and N-hydroxyethyl-2-pyrrolidone; imidazolidinones such as 1,3-dimethyl-2-imidazolidinone, 1,3-diethyl-2-imidazolidinone and 1,3-diisopropyl-2-imidazolidinone; lactones such as γ-butyrolactone and δ-valerolactone; polyhydric alcohols and derivatives thereof such as ethylene glycol, propylene glycol, ethylene glycol monomethyl ether, ethylene glycol monoethyl ether, ethylene glycol monobutyl ether, ethylene glycol monomethyl ether acetate, ethylene glycol monoethyl ether acetate, diethylene glycol, diethylene glycol monomethyl ether, diethylene glycol monoethyl ether and diethylene glycol monobutyl ether; and the like. The (D) organic solvent may include a combination of two or more of these water-soluble organic solvents, together with the N,N-dialkyl fatty acid amide represented by formula (d-1).

When the (D) organic solvent includes a water-soluble organic solvent in addition to the N,N-dialkyl fatty acid amide represented by formula (d-1), the content of the water-soluble organic solvent in the (D) organic solvent is preferably 80% by mass or less, more preferably 70% by mass or less, and most preferably 50% by mass or less.

The amount of the (D) organic solvent in the stripping solution is preferably 1.0% to 90% by mass and more preferably 60% to 80% by mass. The amount of the N,N-dialkyl fatty acid amide represented by formula (d-1) in the (D) organic solvent is preferably 1.0% to 90% by mass and preferably 30% to 80% by mass, with respect to the mass of the stripping solution. The stripping solution, having a property of etching rate which hardly changes even if continuously used, can be obtained through a simple process, i.e., addition of such an amount of the (D) organic solvent comprising the N,N-dialkyl fatty acid amide represented by formula (d-1) to the stripping solution.

### Other Component

The stripping solution according to the present invention may further contain an anti-corrosion agent.

The anti-corrosion agent is not particularly limited, and a conventionally well-known anti-corrosion agent may be used, which is preferably a benzotriazole compound or a mercapto group-containing compound.

The benzotriazole compound includes compounds represented by the following general formula (e-1).

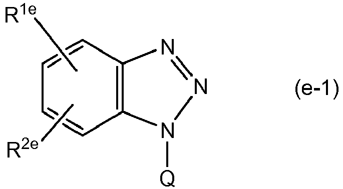

In the above general formula (e-1), R^{1e} and R^{2e} each independently represent a hydrogen atom, a hydrocarbon group having 1 to 10 carbon atoms which may include a substituent, a carboxyl group, an amino group, a hydroxyl group, a cyano group, a formyl group, a sulfonylalkyl group, or a sulfo group, and Q represents a hydrogen atom, a hydroxyl group, a hydrocarbon group having 1 to 14 carbon atoms which may include a substituent (wherein however, the hydrocarbon group may be interrupted by an amide bond or an ester bond), or a group represented by the following general formula (e-2).

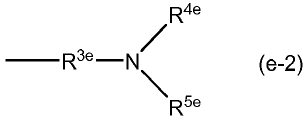

In the above general formula (e-2), R^{3e} represents an alkylene group having 1 to 6 carbon atoms, and R^{4e} and R^{5e} each independently represent a hydrogen atom, a hydroxyl group, or a hydroxyalkyl group or an alkoxyalkyl group having 1 to 6 carbon atoms.

In each of the definitions of R^{1e}, R^{2e} and Q in the above general formula (e-1), the hydrocarbon group may be either an aromatic hydrocarbon group or an aliphatic hydrocarbon group, may include an unsaturated bond, and may be a linear, branched or cyclic hydrocarbon group. The aromatic hydrocarbon group may be for example, a phenyl group, a p-tolyl group, or the like. The linear aliphatic hydrocarbon group may be for example, a methyl group, an n-propyl group, a vinyl group, or the like. The branched aliphatic hydrocarbon group may be for example, an i-butyl group, a t-butyl group, or the like. The cyclic aliphatic hydrocarbon group may be for example, a cyclopentyl group, a cyclohexyl group, or the like. The hydrocarbon group including a substituent may be for example, a hydroxyalkyl group, an alkoxyalkyl group, or the like.

Q in the above general formula (e-1) is preferably a group represented by the above general formula (e-2). In particular, of the groups represented by the above general formula (e-2), it is preferred that R^{4e} and R^{5e} be each independently selected from a hydroxyalkyl group or an alkoxyalkyl group having 1 to 6 carbon atoms.

Furthermore Q is preferably selected so that the compound represented by the above general formula (e-1) exhibits water-soluble properties. More specifically, a hydrogen atom, an alkyl group having 1 to 3 carbon atoms (i.e., a methyl group, an ethyl group, a propyl group or an isopropyl group), a hydroxyalkyl group having 1 to 3 carbon atoms, a hydroxyl group and the like are preferred.

The benzotriazole compound more specifically includes benzotriazole, 5,6-dimethylbenzotriazole, 1-hydroxybenzotriazole, 1-methylbenzotriazole, 1-aminobenzotriazole, 1-phenylbenzotriazole, 1-hydroxymethylbenzotriazole, methyl 1-benzotriazole carboxylate, 5-benzotriazole carboxylic acid, 1-methoxybenzotriazole, 1-(2,2-dihydroxyethyl)-benzotriazole, 1-(2,3-dihydroxypropyl)benzotriazole; and 2,2'-{[(4-methyl-1H-benzotriazole-1-yl)methyl]imino}bisethanol, 2,2'-{[(5-methyl-1H-benzotriazole-1-yl)methyl]imino}bisethanol, 2,2'-{[(4-methyl-1H-benzotriazole-1-yl)methyl]imino}bisethane, 2,2'-{[(4-methyl-1H-benzotriazole-1-yl)methyl]imino}bispropane and the like that are commercially available from BASF as "IREGAMET" series.

Of the above compounds, 1-(2,3-dihydroxypropyl)-benzotriazole, 2,2'-{[(4-methyl-1H-benzotriazole-1-yl)methyl]imino}bisethanol, 2,2'-{[(5-methyl-1H-benzotriazole-1-yl)methyl]imino}bisethanol, and the like are preferable. These benzotriazole compounds may be used alone, or in combination of two or more compounds.

The mercapto group-containing compound above is preferably a compound containing a hydroxyl group and/or a carboxyl group on at least one of the α-position and the β-position of a carbon atom that is bonded to the mercapto group. More specifically, such compounds include 1-thioglycerol, 3-(2-aminophenylthio)-2-hydroxypropylmercaptan, 3-(2-hydroxyethylthio)-2-hydroxypropylmercaptan, 2-mercaptopropionic acid, 3-mercaptopropionic acid, or the like. Of the above compounds, use of 1-thioglycerol is particularly preferred.

These mercapto group-containing compounds may be used alone, or in combination of two or more compounds.

When the anti-corrosion agent is contained, the content in the stripping solution is preferably 0.1 to 10% by mass, and more preferably 0.5 to 5% by mass.

Also, the stripping solution according to the present invention may further contain a surfactant.

The surfactant is not particularly limited, and a conventionally well-known surfactant may be used, which is preferably an acetylene alcohol based surfactant.

When the surfactant is contained, the content in the stripping solution is preferably 0.01 to 5% by mass, and more preferably 0.05 to 2% by mass.

Due to essentially containing the components (A) to (C), the stripping solution according to the present invention can have stripping properties of residual materials of a photoresist pattern and etching residual materials effectively balanced with anticorrosion properties on metals (particularly Al and Al alloys). Therefore, the stripping solution according to the present invention can be suitably used in forming metal wiring patterns configured with Al or an Al alloy, for example.

In addition, the stripping solution according to the present invention is less likely to be accompanied by alteration of the composition even if continuously used for a long period of time; therefore, the present stripping solution is suitable in the case of recycling a stripping solution.

### Method for Forming a Pattern

The method for forming a pattern according to the present invention includes: etching a substrate using a photoresist pattern provided on the substrate as a mask; then ashing the photoresist pattern; and thereafter stripping away the residual materials of the photoresist pattern and etching residual materials using the stripping solution according to the present invention. Hereinafter, one example of the method for forming a pattern according to the present invention will be explained in detail.

The substrate on which a metal film has been formed is exemplified by substrates on which a metal film has been formed, the metal being aluminum (Al); an aluminum alloy (Al alloy) such as aluminum-silicon (Al-Si), aluminum-copper (Al-Cu) or aluminum-silicon-copper (Al-Si-Cu); titanium (Ti); a titanium alloy (Ti alloy) such as titanium nitride (TiN) or titanium tungsten (TiW); tantalum (Ta), tantalum nitride (TaN), tungsten (W), tungsten nitride (WN), copper (Cu) or the like. The method for forming a pattern according to the present invention is particularly suited in the case in which metal film configured with Al or an Al alloy has been formed on a substrate.

Furthermore, the photoresist composition is exemplified by: (i) a positive photoresist composition containing a naphthoquinonediazide compound and a novolak resin; (ii) a positive photoresist composition containing a compound that generates an acid by exposure, a compound that increases its solubility in an aqueous alkali solution through decomposition by an acid, and an alkali-soluble resin; (iii) a positive photoresist composition containing a compound that generates an acid by exposure, and an alkali-soluble resin having a group that increases its solubility in an aqueous alkali solution through decomposition by an acid; and (iv) a negative photoresist composition containing a compound that generates an acid by exposure, a crosslinking agent, and an alkali-soluble resin, and the like, but not limited thereto.

Next, the photoresist film is selectively exposed. The exposure may be carried out on the photoresist film with a light source that emits an actinic radiation such as an ultraviolet ray, a far ultraviolet ray, an excimer laser, an X-ray or an electron beam, for example, a low-pressure mercury lamp, a high-pressure mercury lamp, an ultrahigh-pressure mercury lamp, a xenon lamp or the like through a desired mask pattern, or an electron beam may be directly irradiated on the photoresist film.

Thereafter, a heat treatment (PEB) is carried out as needed.

Next, the exposed photoresist film is developed using a developer solution to obtain a predetermined photoresist pattern. The development method may be an immersion method, a puddling method, a spray coating method, and the like.

Thereafter, a heat treatment (post-baking) is carried out if necessary.

Subsequently, using the formed photoresist pattern as a mask, the metal film is selectively etched. The etching may be any one of wet etching and dry etching, or a combination thereof, but dry etching is preferred.

Next, the photoresist pattern is ashed.

It is to be noted that etching residual materials, as well as residual materials of modified photoresist pattern often remain on the ashed substrate.

Then, the residual materials of the photoresist pattern and etching residual materials are stripping away using the stripping solution according to the present invention. In the case in which a metal film configured with Al or an Al alloy is formed on the substrate, the residual materials may include Al₂O₃, AlCl₃, AlF₃, SiO₂, and the like. The method for stripping is exemplified by an immersion method, a spray coating method and the like, and the treatment may be carried out by either a batch-wise processing or a single wafer processing. Time period for the stripping is not particularly limited, and is typically about 10 to 30 min in a batch-wise processing and about 0.5 to 3 min in a single wafer processing. The stripping solution according to the present invention is preferably used in a single wafer processing. The temperature of the stripping solution is not particularly limited, and is typically about 25 to 70°C.

Thereafter, a rinse treatment with pure water, a lower alcohol or the like, and a dry treatment may be also carried out.

The foregoing steps enable a metal wiring pattern to be formed on the substrate.

### EXAMPLES

Hereinafter, the present invention will be explained in more detail by way of Examples of the present invention, but the present invention is not limited to the following Examples.

### (Preparation of Removing Liquid)

Stripping solutions were prepared in accordance with compositions and amounts blended as shown in Tables 1 to 6 below. It is to be noted that each reagent employed was a commercially available product in general, unless otherwise stated in particular. In addition, the value in parentheses in Tables is presented by a unit on a basis of % by mass, unless otherwise stated in particular. In Examples 29 to 32, a solvent mixture of DMIB and NMP at a mass ratio of 1:1 was used as the water-soluble organic solvent.

**[Table 1]**

| | Hydrofluoric acid | Basic compound | Ratio of normality (basic compound/ hydrofluoric acid) | Water | Water-soluble organic solvent |
|---|---|---|---|---|---|
| Ex. 1 | HF (0.12) | DETA (0.05) | 0.25 | Water (25) | DMIB (Remainder) |
| Ex. 2 | HF (0.24) | DETA (0.11) | 0.25 | Water (25) | DMIB (Remainder) |
| Ex. 3 | HF (0.15) | TETA (0.07) | 0.26 | Water (25) | DMIB (Remainder) |
| Ex. 4 | HF (0.24) | TETA (0.07) | 0.16 | Water (25) | DMIB (Remainder) |
| Ex. 5 | HF (0.32) | DETA (0.14) | 0.25 | Water (25) | DMIB (Remainder) |
| Ex. 6 | HF (0.08) | DETA (0.01) | 0.10 | Water (25) | DMIB (Remainder) |
| Ex. 7 | HF (0.12) | DETA (0.02) | 0.10 | Water (25) | DMIB (Remainder) |
| Ex. 8 | HF (0.16) | DETA (0.03) | 0.10 | Water (25) | DMIB (Remainder) |
| Ex. 9 | HF (0.32) | DETA (0.06) | 0.10 | Water (25) | DMIB (Remainder) |
| Ex. 10 | HF (0.08) | DETA (0.03) | 0.25 | Water (25) | DMIB (Remainder) |

**[Table 2]**

| | Hydrofluoric acid | Basic compound | Ratio of normality (basic compound/ hydrofluoric acid) | Water | Water-soluble organic solvent |
|---|---|---|---|---|---|
| Ex. 11 | HF (0.16) | DETA (0.07) | 0.25 | Water (25) | DMIB (Remainder) |
| Ex. 12 | HF (0.20) | DETA (0.08) | 0.25 | Water (25) | DMIB (Remainder) |
| Ex. 13 | HF (0.28) | DETA (0.12) | 0.25 | Water (25) | DMIB (Remainder) |
| Ex. 14 | HF (0.12) | DETA (0.10) | 0.50 | Water (25) | DMIB (Remainder) |
| Ex. 15 | HF (0.16) | DETA (0.14) | 0.50 | Water (25) | DMIB (Remainder) |
| Ex. 16 | HF (0.24) | DETA (0.21) | 0.50 | Water (25) | DMIB (Remainder) |
| Ex. 17 | HF (0.24) | DETA (0.31) | 0.75 | Water (25) | DMIB (Remainder) |
| Ex. 18 | HF (0.12) | DETA (0.21) | 1.00 | Water (25) | DMIB (Remainder) |
| Ex. 19 | HF (0.16) | DETA (0.28) | 1.00 | Water (25) | DMIB (Remainder) |
| Ex. 20 | HF (0.24) | DETA (0.42) | 1.00 | Water (25) | DMIB (Remainder) |

**[Table 3]**

| | Hydrofluoric acid | Basic compound | Ratio of normality (basic compound/ hydrofluoric acid) | Water | Water-soluble organic solvent |
|---|---|---|---|---|---|
| Ex. 21 | HF (0.12) | DETA (0.31) | 1.50 | Water (25) | DMIB (Remainder) |
| Ex. 22 | HF (0.16) | DETA (0.41) | 1.50 | Water (25) | DMIB (Remainder) |
| Ex. 23 | HF (0.24) | DETA (0.63) | 1.50 | Water (25) | DMIB (Remainder) |
| Ex. 24 | HF (0.24) | DETA (0.73) | 1.75 | Water (25) | DMIB (Remainder) |
| Ex. 25 | HF (0.24) | DETA (0.84) | 2.00 | Water (25) | DMIB (Remainder) |
| Ex. 26 | HF (0.24) | DETA (1.05) | 2.50 | Water (25) | DMIB (Remainder) |
| Ex. 27 | HF (0.12) | DETA (0.62) | 3.00 | Water (25) | DMIB (Remainder) |
| Ex. 28 | HF (0.24) | DETA (1.24) | 3.00 | Water (25) | DMIB (Remainder) |
| Ex. 29 | HF (0.12) | DETA (0.05) | 0.25 | Water (25) | DMIB/NMP (Remainder) |
| Ex. 30 | HF (0.24) | DETA (0.11) | 0.25 | Water (25) | DMIB/NMP (Remainder) |
| Ex. 31 | HF (0.15) | TETA (0.07) | 0.26 | Water (25) | DMIB/NMP (Remainder) |
| Ex. 32 | HF (0.24) | TETA (0.07) | 0.16 | Water (25) | DMIB/NMP (Remainder) |

**[Table 4]**

| | Hydrofluoric acid | Basic compound | Ratio of normality (basic compound/ hydrofluoric acid) | Water | Water-soluble organic solvent |
|---|---|---|---|---|---|
| Comp. Ex. 1 | HF (0.24) | - | 0.00 | Water (25) | DMIB (Remainder) |
| Comp. Ex. 2 | NH₄F (0.45) | | 1.00 | Water (25) | DMIB (Remainder) |
| Comp. Ex. 3 | HF (0.24) | NH₃ (0.10) | 0.50 | Water (25) | DMIB (Remainder) |
| Comp. Ex. 4 | HF (0.24) | MEA (0.73) | 1.00 | Water (25) | DMIB (Remainder) |
| Comp. Ex. 5 | HF (0.24) | MEA (0.37) | 0.50 | Water (25) | DMIB (Remainder) |
| Comp. Ex. 6 | HF (0.24) | TEtA (1.79) | 1.00 | Water (25) | DMIB (Remainder) |
| Comp. Ex. 7 | HF (0.24) | TEtA (0.90) | 0.50 | Water (25) | DMIB (Remainder) |
| Comp. Ex. 8 | HF (0.24) | Butylamine (0.87) | 1.00 | Water (25) | DMIB (Remainder) |
| Comp. Ex. 9 | HF (0.24) | Isoamylamine (1.04) | 1.00 | Water (25) | DMIB (Remainder) |
| Comp. Ex. 10 | HF (0.24) | Dimethyl dodecylamine (2.22) | 1.00 | Water (25) | DMIB (Remainder) |

**[Table 5]**

| | Hydrofluoric acid | Basic compound | Ratio of normality (basic compound/ hydrofluoric acid) | Water | Water-soluble organic solvent |
|---|---|---|---|---|---|
| Comp. Ex. 11 | HF (0.24) | DBU (1.82) | 1.00 | Water (25) | DMIB (Remainder) |
| Comp. Ex. 12 | HF (0.24) | Benzotriazole (1.43) | 1.00 | Water (25) | DMIB (Remainder) |
| Comp. Ex. 13 | HF (0.24) | Pyridine (0.95) | 1.00 | Water (25) | DMIB (Remainder) |
| Comp. Ex. 14 | HF (0.24) | DL-Alaninol (0.90) | 1.00 | Water (25) | DMIB (Remainder) |
| Comp. Ex. 15 | HF (0.12) | PMDETA (0.08) | 0.25 | Water (25) | DMIB (Remainder) |
| Comp. Ex. 16 | HF (0.24) | PMDETA (0.17) | 0.25 | Water (25) | DMIB (Remainder) |
| Comp. Ex. 17 | HF (0.15) | PMDETA (0.07) | 0.25 | Water (25) | DMIB (Remainder) |
| Comp. Ex. 18 | HF (0.08) | - | 0.0 | Water (25) | DMIB (Remainder) |
| Comp. Ex. 19 | HF (0.12) | - | 0.0 | Water (25) | DMIB (Remainder) |
| Comp. Ex. 20 | HF (0.32) | - | 0.0 | Water (25) | DMIB (Remainder) |

**[Table 6]**

| | Hydrofluoric acid | Basic compound | Ratio of normality (basic compound/ hydrofluoric acid) | Water | Water-soluble organic solvent |
|---|---|---|---|---|---|
| Comp. Ex. 21 | HF (0.12) | DETA (0.05) | 0.25 | Water (25) | NMP (Remainder) |
| Comp. Ex. 22 | HF (0.24) | DETA (0.11) | 0.25 | Water (25) | NMP (Remainder) |
| Comp. Ex. 23 | HF (0.12) | DETA (0.05) | 0.25 | Water (25) | PG (Remainder) |
| Comp. Ex. 24 | HF (0.12) | DETA (0.05) | 0.25 | Water (25) | DMSO (Remainder) |

The abbreviations in Tables 1 to 6 are as follows:
DETA: diethyleneamine
TETA: triethylenetetramine
MEA: monoethanolamine
TEtA: triethanolamine
DBU: 1,8-diazabicyclo[5.4.0]undecene-7
PMDETA: pentamethyldiethylenetriamine
DMIB: N,N-dimethylisobutylamide
NMP: N-methyl-2-pyrrolidone
PG: propylene glycol
DMSO: dimethyl sulfoxide

### (Alteration of Film Thickness of Al-Si-Cu Film)

A silicon wafer on which an Al-Si-Cu film having a thickness of about 0.3 µm had been vapor deposited was immersed in a stripping solution warmed to 25°C or 35°C for 10 min, and the amount of the alteration of the film thickness after immersion as compared with before the immersion was determined. The results are shown in Tables 7 to 9.

### (Stripping Characteristics and Anticorrosion Properties)

TFR-H (manufactured by Tokyo Ohka Kogyo Co., Ltd.) that is a photoresist composition for TFT was spin-coated on a silicon wafer on which an Al-Si-Cu film having a thickness of about 0.3 µm had been vapor deposited, and prebaked at 90°C for 90 sec to form a photoresist film having a film thickness of 2.0 µm. This photoresist film was irradiated with an ultraviolet ray using a stepper NSR-2005i10D (manufactured by Nikon Corporation) through a mask pattern, and developed with a 2.38% by weight aqueous tetramethylammonium hydroxide solution, followed by subjecting to post-baking at 150°C for 90 sec to obtain a line-and-space photoresist pattern having a thickness of 0.6 µm.

Thereafter, the Al-Si-Cu film was etched with a mixed gas of chlorine and boron trichloride as an etchant using an etching apparatus TSS-6000 (manufactured by Tokyo Ohka Kogyo Co., Ltd.) under a pressure of 5 mmTorr and a stage temperature of 20°C for 168 sec on the substrate on which the photoresist pattern had been formed, whereby an Al-Si-Cu wiring pattern was formed. Then, an after corrosion treatment was carried out using a mixed gas of oxygen and trifluoromethane under a pressure of 20 mmTorr, at a stage temperature of 20°C for 30 sec.

Next, the photoresist pattern was ashed using an ashing apparatus TCA-3822 (manufactured by Tokyo Ohka Kogyo Co., Ltd.) under a pressure of 1.2 mmTorr, at a stage temperature of 220°C for 40 sec.

Subsequently, the ashed silicon wafer was immersed for 45 sec in the stripping solution warmed to 35°C in a single wafer processing to strip away residual materials of the photoresist pattern and etching residual materials. Then, anticorrosion properties were evaluated as: "Good" when corrosion of the Al-Si-Cu wiring pattern was not found; and "Bad" when the corrosion was found. In addition, the silicon wafer after subjecting to the stripping treatment was observed by an optical microscope and a scanning electron microscope (SEM), and stripping characteristics were evaluated as: "Good" when residual materials of the photoresist pattern and etching residual materials did not remain; and "Bad" when the residual materials remained. The results are shown in Tables 7 to 9. It is to be noted that in the case in which the anticorrosion properties were evaluated as "Bad", corrosion excessively progressed and thus observation of residual materials of the photoresist pattern and etching residual materials failed; therefore, the denotation of the evaluation of the stripping characteristics was "NA" in Tables.

### (Alteration of Etching Rate)

A silicon wafer on which an Al₂O₃ film having a thickness of about 0.2 µm had been vapor deposited was immersed for 10 min in the stripping solution warmed to 35°C, and an etching rate (Å/min) was calculated from the alteration of the film thickness after the immersion as compared to that before the immersion. In addition, an etching rate (Å/min) was calculated in a similar manner to that described above using the stripping solution which had been continuously warmed at 35°C over 48 hrs. Then, the evaluation was made as "Good" when the amount of change in etching rate was less than 5 Å/min; as "Fair" when the amount of change was no less than 5 Å/min and less than 10 Å/min; and as "Bad" when the amount of change was no less than 10. The results are shown in Tables 7 to 9.

### (Alteration of Composition)

The stripping solution was warmed at 35°C for 48 hrs, and the change of the concentration of the basic compound after the warming as compared with that before warming was determined. Then, the evaluation was made as "Good" when the change of the concentration was less than 0.15%; and as "B" when the change was no less than 0.15%. The results are shown in Tables 7 to 9.

**[Table 7]**

| | Alternation of Al-Si-Cu film thickness (nm) (treatment at 35 °C for 10 min.) | Alternation of Al-Si-Cu film thickness (nm) (treatment at 35 °C for 10 min.) | Stripping Characteristics | Anti-corrosion properties | Alternation of etching rate | Alternation of composition |
|---|---|---|---|---|---|---|
| Ex. 1 | < 0.1 | < 0.1 | Good | Good | Good | Good |
| Ex. 2 | - | < 0.1 | Good | Good | Good | Good |
| Ex. 3 | - | 1.2 | Good | Good | Good | Good |
| Ex 4 | - | < 0.1 | Good | Good | Good | Good |
| Ex. 5 | - | 0.18 | Good | Good | Good | Good |
| Ex. 6 | - | 1.2 | Good | Good | Good | Good |
| Ex. 7 | - | < 0.1 | Good | Good | Good | Good |
| Ex. 8 | - | 1.16 | Good | Good | Good | Good |
| Ex. 9 | - | 0.7 | Good | Good | Good | Good |
| Ex. 10 | - | < 0.1 | Good | Good | Good | Good |
| Ex. 11 | - | < 0.1 | Good | Good | Good | Good |
| Ex. 12 | - | 4.5 | Good | Good | Good | Good |
| Ex. 13 | - | 0.7 | Good | Good | Good | Good |
| Ex. 14 | - | 2.32 | Good | Good | Good | Good |
| Ex. 15 | - | 3.2 | Good | Good | Good | Good |
| Ex. 16 | - | 9.8 | Good | Good | Good | Good |
| Ex. 17 | - | 9.7 | Good | Good | Good | Good |
| Ex. 18 | - | 10.6 | Good | Good | Good | Good |
| Ex. 19 | - | 16 | Good | Good | Good | Good |
| Ex. 20 | - | 22.1 | Good | Good | Good | Good |

**[Table 8]**

| | Alternation of Al-Si-Cu film thickness (nm) (treatment at 35 °C for 10 min.) | Alternation of Al-Si-Cu film thickness (nm) (treatment at 35 °C for 10 min.) | Stripping Characteristics | Anti-corrosion properties | Alternation of etching rate | Alternation of composition |
|---|---|---|---|---|---|---|
| Ex. 21 | - | 9.2 | Good | Good | Good | Good |
| Ex. 22 | - | 14.6 | Good | Good | Good | Good |
| Ex. 23 | - | < 0.1 | Good | Good | Good | Good |
| Ex. 24 | - | 16.6 | Good | Good | Good | Good |
| Ex. 25 | - | 15.7 | Good | Good | Good | Good |
| Ex. 26 | - | 13.4 | Good | Good | Good | Good |
| Ex. 27 | - | 6.7 | Good | Good | Good | Good |
| Ex. 28 | - | 11.1 | Good | Good | Good | Good |
| Ex. 29 | < 0.1 | < 0.1 | Good | Good | Good | Good |
| Ex. 30 | - | < 0.1 | Good | Good | Good | Good |
| Ex. 31 | - | 1.2 | Good | Good | Good | Good |
| Ex. 32 | - | < 0.1 | Good | Good | Good | Good |

**[Table 9]**

| | Alternation of Al-Si-Cu film thickness (nm) (treatment at 35 °C for 10 min.) | Alternation of Al-Si-Cu film thickness (nm) (treatment at 35 °C for 10 min.) | Stripping Characteristics | Anti-corrosion properties | Alternation of etching rate | Alternation of composition |
|---|---|---|---|---|---|---|
| Comp. Ex. 1 | - | 40.3 | NA | Bad | Good | Good |
| Comp. Ex. 2 | - | < 0.1 | Good | Good | Bad | Bad |
| Comp. Ex. 3 | - | < 0.1 | Good | Good | Bad | Bad |
| Comp. Ex. 4 | - | 33.5 | NA | Bad | Good | Good |
| Comp. Ex. 5 | - | 52.3 | NA | Bad | Good | Good |
| Comp. Ex. 6 | - | 35.0 | NA | Bad | Good | Good |
| Comp. Ex. 7 | - | 36.8 | NA | Bad | Good | Good |
| Comp. Ex. 8 | 9.0 | - | NA | Bad | Good | Good |
| Comp. Ex. 9 | 5.4 | - | NA | Bad | Good | Good |
| Comp. Ex. 10 | 13.1 | - | NA | Bad | Good | Good |
| Comp. Ex. 11 | 11.4 | - | NA | Bad | Good | Good |
| Comp. Ex. 12 | 10.3 | - | NA | Bad | Good | Good |
| Comp. Ex. 13 | 54.0 | - | NA | Bad | Good | Good |
| Comp. Ex. 14 | 11.0 | - | NA | Bad | Good | Good |
| Comp. Ex. 15 | - | 19.8 | NA | Bad | Good | Good |
| Comp. Ex. 16 | - | 23.6 | NA | Bad | Good | Good |
| Comp. Ex. 17 | - | 17.5 | NA | Bad | Good | Good |
| Comp. Ex. 18 | - | 0.8 | NA | Bad | Bad | Bad |
| Comp. Ex. 19 | - | 21.9 | NA | Bad | Bad | Bad |
| Comp. Ex. 20 | - | 59.7 | NA | Bad | Bad | Bad |
| Comp. Ex. 21 | < 0.1 | < 0.1 | Good | Good | Fair | Good |
| Comp. Ex. 22 | - | < 0.1 | Good | Good | Fair | Good |
| Comp. Ex. 23 | - | < 0.1 | Good | Good | Fair | Good |
| Comp. Ex. 24 | | < 0.1 | Good | Good | Fair | Good |

Tables 7 to 9 demonstrate that photoresist pattern residues and etching residues can be effectively stripped away and an excellent anticorrosion property with respect to Al-Si-Cu is exhibited by the stripping solutions of Examples 1 to 32 containing a basic compound represented by formula (b-1) as a counter amine of hydrofluoric acid and an organic solvent comprising DMIB as an N,N-dialkylamide having a predetermined structure. Tables 7 to 9 also demonstrate that there is scarce occurrence of change in etching rate and change in composition in the stripping solutions, even when heated at 35°C for a long time, and are suitable for cyclic use.

On the other hand, the stripping solution of Comparative Example 2 containing ammonium fluoride and the stripping solution of Comparative Example 3 containing ammonia as a counter amine of hydrofluoric acid, effectively stripped away photoresist pattern residues and etching residues and exhibited an excellent anticorrosion property with respect to Al-Si-Cu. However, when heated at 35°C for a long time, there was an occurrence of change in etching rate and a change in composition in these stripping solutions, and were unsuitable for cyclic use.

The stripping solutions of Comparative Examples 1 and 18 to 20 not containing any basic compound and the stripping solutions of Comparative Examples 4 to 17 containing basic compounds, other than ammonia, as counter amines of hydrofluoric acid were low in anticorrosion property with respect to Al-Si-Cu.

Although the stripping solution of Comparative Examples 21 to 24 not containing any N,N-dialkylamide having a predetermined structure as an organic solvent exhibited an excellent anticorrosion property with respect to Al-Si-Cu and there was a scarce occurrence of change in composition even when heated at 35°C for a long time, a change in etching rate readily occurred when heated at 35°C for a long time.

## Claims

1. A stripping solution for photolithography **characterized in that** it comprises:
(A) hydrofluoric acid;
a (B) basic compound; represented by formula (b-1): 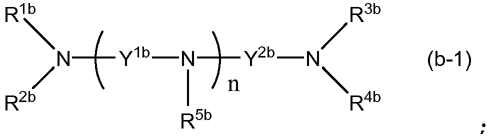
(C) water; and
a (D) organic solvent, wherein
the (D) organic solvent comprises an N,N-dialkyl fatty acid amide represented by formula (d-1): 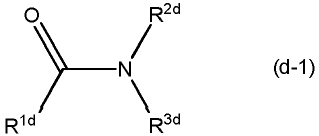
in formula (b-1), R^{1b} to R^{5b} each independently represent a hydrogen atom or an alkyl group having 1 to 6 carbon atoms and optionally substituted with a hydroxy group, a carboxyl group, an amino group, or a phosphonic acid group, provided that at least one of R^{1b} to R^{5b} represents a hydrogen atom;
one of R^{1b} to R^{4b} and R^{5b} optionally bind with each other to form a ring structure;
Y^{1b} and Y^{2b} each independently represent an alkylene group having 1 to 3 carbon atoms;
n represents an integer of 0 to 5; and
provided that n is 2 or greater, the plurality of R^{5b}s are each the same or different, the plurality of Y^{1b}s are each the same or different, and R^{5b}s optionally bind with each other to form a ring structure,
in formula (d-1), R^{1d} represents an isopropyl group or a 1-hydroxy-1-methylethyl group; and
R^{2d} and R^{3d} each independently represent an alkyl group having 1 to 4 carbon atoms.

2. The stripping solution according to Claim 1, wherein
the N,N-dialkyl fatty acid amide represented by formula (d-1) comprises at least one selected from N,N-dimethylisobutylamide and 2-hydroxy-N,N,2-trimethylpropaneamide.

3. The stripping solution according to Claim 1 or 2, wherein
the ratio of the normality of the (B) basic compound to the normality of the (A) hydrofluoric acid is 0.1 to 3.0.

4. Use of the stripping solution according to any one of Claims 1 to 3 for forming a metal wiring pattern comprising Al or an Al alloy.

5. A pattern forming process **characterized in that** it comprises:
etching a substrate using a photoresist pattern provided on the substrate as a mask;
ashing the photoresist pattern after the etching; and
stripping away the photoresist pattern residues and etching residues using the stripping solution according to any one of Claims 1 to 4.

## Patentansprüche

1. Abziehlösung für die Photolithographie, **dadurch gekennzeichnet, dass** sie Folgendes umfasst:
(A) Flusssäure;
(B) eine basische Verbindung; die von der Formel (b-1) dargestellt wird: 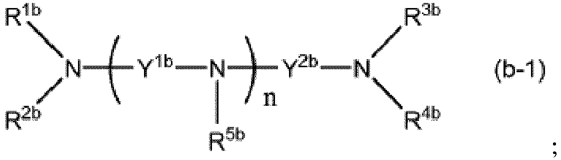
(C) Wasser; und
(D) ein organisches Lösungsmittel, wobei
(D) das organische Lösungsmittel ein N, N-Dialkylfettsäureamid umfasst, das von der Formel (d-1) dargestellt wird: 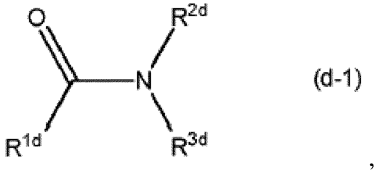
wobei in Formel (b-1), R^{1b} bis R^{5b} jeweils unabhängig für ein Wasserstoffatom oder eine Alkylgruppe stehen, die 1 bis 6 Kohlenstoffatome aufweist und gegebenenfalls mit einer Hydroxygruppe, einer Carboxylgruppe, einer Aminogruppe oder einer Phosphonsäuregruppe substituiert ist, vorausgesetzt, dass mindestens einer von R^{1b} bis R^{5b} für ein Wasserstoffatom steht;
einer von R^{1b} bis R^{4b} und R^{5b} sich gegebenenfalls aneinanderbinden, um eine Ringstruktur zu bilden;
Y^{1b} und Y^{2b} jeweils unabhängig für eine Alkylengruppe stehen, die 1 bis 3 Kohlenstoffatome aufweist;
n für eine ganze Zahl von 0 bis 5 steht; und
vorausgesetzt, dass n 2 oder höher ist, die Vielzahl von R^{5b} jeweils gleich oder verschieden ist, die Vielzahl von Y^{1b} jeweils gleich oder verschieden ist und die R^{5b} sich gegebenenfalls aneinanderbinden, um eine Ringstruktur zu bilden,
in Formel (d-1), R^{1d} für eine Isopropylgruppe oder eine 1-Hydroxy-1-methylethylgruppe steht; und
R^{2d} und R^{3d} jeweils unabhängig für eine Alkylgruppe stehen, die 1 bis 4 Kohlenstoffatome aufweist.

2. Abziehlösung nach Anspruch 1, wobei das N, N-Dialkylfettsäureamid, das von der Formel (d-1) dargestellt wird, mindestens eines umfasst, das aus N, N-Dimethylisobutylamid und 2-Hydroxy-N, N, 2-trimethylpropanamid ausgewählt ist.

3. Abziehlösung nach Anspruch 1 oder 2, wobei das Verhältnis der Normalität (B) der basischen Verbindung zu der Normalität (A) der Flusssäure 0,1 bis 3,0 beträgt.

4. Verwendung der Abziehlösung nach einem der Ansprüche 1 bis 3 zum Bilden eines Metallverdrahtungsmusters, das Al oder eine Al-Legierung umfasst.

5. Musterbildungsverfahren, **dadurch gekennzeichnet, dass** es Folgendes umfasst:
Ätzen eines Substrats unter Verwendung eines Photoresistmusters, das auf dem Substrat als eine Maske bereitgestellt ist;
Veraschen des Photoresistmusters nach dem Ätzen; und
Abziehen der Photoresistmusterrückstände und der Ätzrückstände unter Verwendung der Abziehlösung nach einem der Ansprüche 1 bis 4.

## Revendications

1. Solution de décapage pour photolithographie **caractérisée en ce qu'**elle comprend :
(A) de l'acide fluorhydrique ;
(B) un composé basique ; représenté par la formule (b-1) : 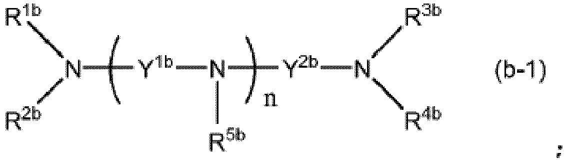
(C) de l'eau; et
(D) un solvant organique, dans laquelle
(D) le solvant organique comprend un amide d'acide gras N,N-dialkylé représenté par la formule (d-1) : 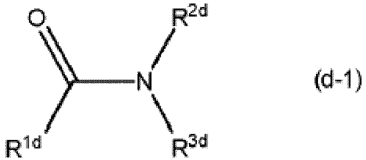
dans la formule (b-1), R^{1b} à R^{5b} représentent chacun indépendamment un atome d'hydrogène ou un groupe alkyle contenant 1 à 6 atomes de carbone et facultativement substitué avec un groupe hydroxy, un groupe carboxyle, un groupe amino ou un groupe acide phosphonique, à condition qu'au moins un parmi R^{1b} à R^{5b} représente un atome d'hydrogène ;
un parmi R^{1b} à R^{4b} et R^{5b} sont liés l'un à l'autre pour former une structure cyclique ;
Y^{1b} et Y^{2b} représentent chacun indépendamment un groupe alkylène contenant 1 à 3 atomes de carbone ;
n représente un nombre entier de 0 à 5 ; et
à condition que n soit 2 ou plus, la pluralité de R^{5b} sont chacun identiques ou différents, la pluralité de Y^{1b} sont chacun identiques ou différents, et les R^{5b} sont facultativement liés les uns aux autres pour former une structure cyclique,
dans la formule (d-1), R^{1d} représente un groupe isopropyle ou un groupe 1-hydroxy-1-méthyléthyle ; et
R^{2d} et R^{3d} représentent chacun indépendamment un groupe alkyle contenant 1 à 4 atomes de carbone.

2. Solution de décapage selon la revendication 1, dans laquelle l'amide d'acide gras N, N-dialkylé représenté par la formule (d-1) comprend au moins un choisi parmi le N, N-diméthylisobutylamide et le 2-hydroxy-N, N, 2-triméthylpropaneamide.

3. Solution de décapage selon la revendication 1 ou 2, dans laquelle le rapport de la normalité (B) du composé basique sur la normalité (A) de l'acide fluorhydrique est de 0,1 à 3,0.

4. Utilisation de la solution de décapage selon l'une quelconque des revendications 1 à 3 pour former un motif de câblage métallique comprenant Al ou un alliage d'Al.

5. Procédé de formation d'un motif **caractérisé en ce qu'**il comprend :
la gravure d'un substrat en utilisant un motif de résine photosensible disposé sur le substrat comme masque ;
la calcination du motif de résine photosensible après la gravure ; et
l'élimination par décapage des résidus du motif de résine photosensible et des résidus de gravure en utilisant la solution de décapage selon l'une quelconque des revendications 1 à 4.
